# EUROPEAN PATENT SPECIFICATION

(11) **EP 3 429 843 B1**
(45) Date of publication and mention of the grant of the patent: **30.06.2021**
(21) Application number: 16908316.9
(22) Date of filing: 07.07.2016
(51) Int. Cl.: B32B 3/26, B32B 15/08, B32B 15/16, B32B 5/30, B32B 5/24, H05K 5/04

(54) **HOUSINGS FOR ELECTRONIC DEVICES FORMED OF METAL FLUOROPOLYMER COMPOSITES**
GEHÄUSE FÜR ELEKTRONISCHE VORRICHTUNGEN AUS METALL-FLUORPOLYMER-VERBUNDWERKSTOFFEN
BOÎTIERS POUR DISPOSITIFS ÉLECTRONIQUES FORMÉS DE COMPOSITES À BASE DE MÉTAL/FLUOROPOLYMÈRE

(43) Date of publication of application: 23.01.2019
(73) Proprietor: Hewlett-Packard Development Company, L.P., Spring TX 77389 (US)
(72) Inventor: HE, Hui, Fort Collins, Colorado 80528 (US); YUEN, Hang-Yan, Fort Collins, Colorado 80528 (US)
(74) Representative: HGF
(86) International application number: PCT/US2016/041346
(87) International publication number: WO 2018/009197

(56) References cited:
- EP-A1- 0 039 869
- EP-A1- 1 133 222
- EP-A2- 1 313 359
- WO-A1-2016/018263
- WO-A1-2016/072987
- WO-A1-2016/080944
- US-A1- 2012 036 733

## Description

### Background

Electronic devices include a housing. A housing of an electronic device may refer to a structural component that encloses an interior of the electronic device. The housing of the electronic device may be subjected to mechanical forces over an operational lifetime of an electronic device. Additionally, electronic devices include electrical components such a memory, processor, etc., that generate heat during operation of the electronic device.
US 2012/036733 A1 discloses a super absorber polymer felt comprising a felt layer and an absorbing layer.
EP 01313359 A2 discloses a method for manufacturing a casing.
EP 133222 A1 discloses a resin case and a mold for producing the case.
EP 0039869 A1 discloses a housing for an electric component.

### Brief Description of the Drawings

Figure 1 illustrates a view of an example of a metal fluoropolymer composite according to the disclosure.
Figure 2 illustrates a view of an example of a metal fluoropolymer composite according to the disclosure.
Figure 3 illustrates a bottom view of an example of an electronic device including a metal fluoropolymer composite according to the disclosure.
Figure 4 illustrates a flow diagram of an example of a method of manufacture of a metal fluoropolymer composite according to the disclosure.

### Detailed Description

During an operational lifetime an electronic device may be subjected to environmental conditions such as liquids (e.g., liquids spilled on a surface of the electronic device) that may cause the electronic device to experience temporary and/or permanent damage. Additionally, operation of an electronic device below a designed threshold operating temperature may be desirable to ensure intended performance of the electronic device and/or avoid thermal degradation of components of the electronic device. Further, a housing of an electronic device may be subjected to mechanical deformation so the housing may desirably provide a sufficient amount of mechanical strength to withstand such deformation.

The invention for which protection is sought is defined in the independent claim. Preferred embodiments are indicated in the dependent claims.

Examples of the disclosure more generally include metal fluoropolymer composites, electronic devices including metal fluoropolymer composites, and methods of manufacture of metal fluoropolymer composites. For example, a metal fluoropolymer composite can include a metal substrate including an opening in a face of the metal substrate, a porous fluoropolymer layer disposed on the face of the metal substrate and overlaying the opening, and a fabric layer disposed on the porous fluoropolymer layer, where the metal fluoropolymer composite is permeable to air but impermeable to liquid water. Notably, in some examples, at least a portion of a housing of an electronic device can be formed of a metal fluoropolymer composite to promote flow of the air through the metal fluoropolymer composite and cool the electronic device while being impermeable to liquid water, as described herein.

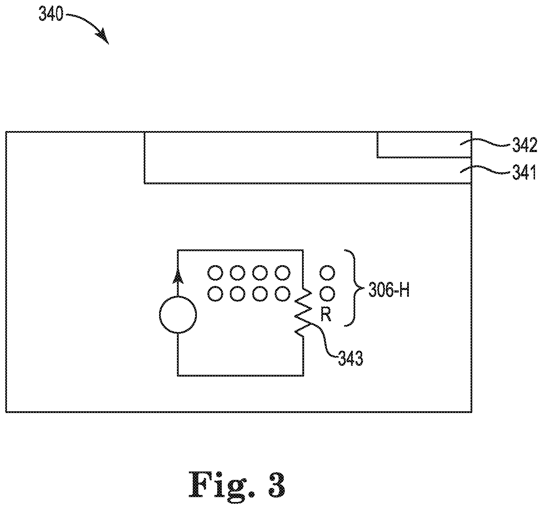

A housing of a device refers to a structural component that encloses at least a portion of an interior of the electronic device. For example, the metal fluoropolymer composite can form at least a portion of a back cover, a front cover, a side cover, and the like, of an electronic device, as described herein with greater detail with respect to Figure 3.

As used herein, an electronic device refers to a device including an electrical circuit. The electronic device can be a consumer electronic device and/or a mobile electronic device. Example of electronic devices include laptop computers, desktop computers, tablets, mobile phones, keyboards, and/or wearable electronic devices (e.g., a watch and/or a heart rate band), among other types of electronic devices.

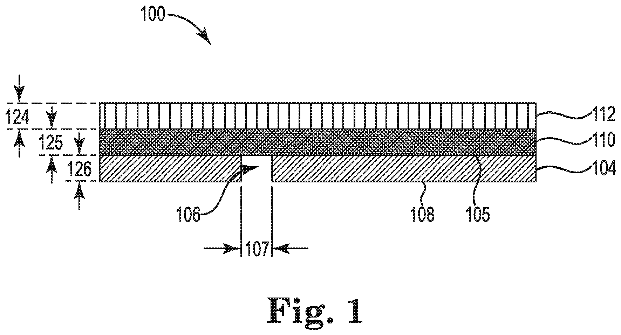

Figure 1 illustrates a view of an example of a metal fluoropolymer composite 100 according to the disclosure. As illustrated in Figure 1, the metal fluoropolymer composite 100 includes a metal substrate 104, a porous fluoropolymer layer, and a fabric layer 112.

The metal substrate 104 can be formed of a metal and/or a metal alloy such as steel, titanium, lithium, aluminum, magnesium, or combinations thereof, among other possibilities. A thickness 126 of the metal substrate 104 can be varied. For example, the thickness 126 of the metal substrate 104 can be varied depending upon a desired application and/or desired amount of mechanical strength of the metal fluoropolymer composite 0. In some examples, the thickness 126 of the metal substrate 104 can be from 0.5 millimeters to 5 millimeters. All individual values and subranges from 0.5 millimeters to 5 millimeters are included.

As illustrated in Figure 1, the metal substrate 104 includes an opening 106 in a face of the metal substrate 104. At least a portion of the opening 106 can pass through the entire thickness 126 of the metal substrate as illustrated in Figure 1 where an entire diameter 107 of the opening 106 passes from a first surface 105 to a second surface 108 of the metal substrate 104.

In some examples, the opening 106 can have a diameter 107 up to 5.0 millimeters. For example, the diameter 107 can be from a lower limit 0.1 millimeters to an upper limit of 1.0 millimeters or 5.0 millimeters.

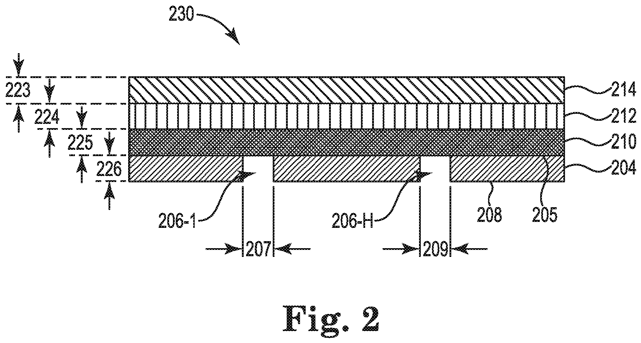

A shape, size, total number, position and/or relative position (e.g., relative to heat producing components and/or to other openings), etc. of the opening 106 can be varied. For example, while Figure 1 illustrates one opening 106 in the metal substrate 104 the total number of openings can be increased to a suitable number of opening to promote aspects of metal fluoropolymer composites. For instance, Figure 2 illustrates that a metal fluoropolymer composite can include a plurality of openings.

The porous fluoropolymer layer 110 can include and/or be formed of a fluoropolymer such as a polytetrafluoroethylene (PTFE), expanded polytetrafluoroethylene (ePTFE), or combinations thereof. For instance, in some examples, the porous fluoropolymer layer 110 can be formed of ePTFE. In some examples, the porous fluoropolymer layer 110 can be formed of PTFE.

The porous fluoropolymer layer 110 includes pores (not shown for ease of illustration). The pores of the porous fluoropolymer layer 110 can have an average pore size of from 0.5 microns to 5 microns. All individual values and subranges from 0.5 microns to 5 microns are included; for example, the average pore size can be from a lower limit of 0.5 microns or 1 micron, to an upper limit of 2 microns or 5 microns. It is noted, a liquid water drop cannot pass the pores of the porous fluoropolymer layer 110, while vapor particles (e.g., water vapor, etc.) can pass the pores of the porous fluoropolymer layer 110.

The porous fluoropolymer layer 110 can have a level of porosity of from 80% to 99%. All individual values and subranges from 99% to 80% are included. In some examples, the porous fluoropolymer layer 110 can have a level of porosity of at least 80%, 85%, 90%, 95%, 96%, 97%, 98%, and/or 99% or higher. Depending on the context, such porosity % can refer to a volume % of the porous fluoropolymer layer 110.

The porous fluoropolymer layer 110 can have a density of from 2.2 grams/centimeter³ to 0.1 grams/centimeter³. All individual values and subranges from 2.2 grams/centimeter³ to 0.1 grams/centimeter³ are included. In some examples, the porous fluoropolymer layer 110 can have of a density of less than or equal to 2.2 grams/centimeter³, 0.5 grams/centimeter³, 0.4 grams/centimeter³, 0.3 grams/centimeter³, or 0.1 grams/centimeter³.

The porous fluoropolymer layer 110 can have a thickness 125 of from 2 millimeters to 0.005 millimeters. All individual values and subranges from 2 millimeters to 0.005 millimeters are included; for example, the thickness 125 can be from a lower limit of 0.005 millimeters, 0.1 millimeters or 0.5 millimeters, to an upper limit of 2 millimeters or 1 millimeter.

As mentioned, the porous fluoropolymer layer 110 is permeable to gases including air and water vapor, but impermeable to liquids such as liquid water. The porous fluoropolymer layer 110 can exhibit liquid impermeability (e.g., repellency) at, for example, a surface thereof, and possess a high contact angle with liquid water. The liquid repellency of the porous fluoropolymer layer 110 may be at least in part be attributed to a size of the pores which allow passage of a gas but not liquid through the metal fluoropolymer composite 100. Depending on the context, the term "size" of an object herein can refer to diameter, length, width, etc., thereof. For example, porous fluoropolymer layer 110 can comprise 1 billion to 15 billion micro-pores per square inch.

The liquid impermeability of the porous fluoropolymer layer 110 can be reflected in the contact angle of the porous fluoropolymer layer 110 with a liquid droplet. For the example, a contact angle with liquid water can be at least 90° 95°, 100°, 105°, 110°, 115°, 120°, 125°, 130° or higher. All individual values and subranges from 90° to 130° (or higher) are included. For instance, a contact angle with liquid water can be 118°, among other possibilities. The liquid impermeability and repellence, as evidenced in the contact angle, can make the porous fluoropolymer layer 110 (and thus the metal fluoropolymer composite 100) unlikely to be wetted by general liquids and/or unlikely to adhere to other materials. The impermeability of the porous fluoropolymer layer 110 with respect to a liquid (e.g., water) can be captured by, for example, less than or equal to 20 volume % of a liquid (e.g., liquid water) being able to pass through the thickness 125 of the porous fluoropolymer layer 110. In some examples, less than or equal to 15 volume %, 10 volume %, 5 volume %, 1 volume %, and/or less than 0.5 volume % can pass through the porous fluoropolymer layer 110.

An air and/or gas permeability of the porous fluoropolymer layer 110 can be reflected in the Frazier number of the porous fluoropolymer layer 110. As used herein, a Frazier number can be calculated in accordance with ASTM D737(Standard Test Method for Air Permeability of Textile Fabrics). For example, the porous fluoropolymer layer 110 can have a Frazier number of from 0.1 to 500. All individual values and subranges from 0.1 to 500 are included. For instance, in some examples, the porous fluoropolymer layer 110 can have a Frazier number of from 0.2 to 450, from 0.5 to 400, from 0.8 to 350, from 1 to 300, from 5 to 250, from 10 to 200, from 20 to 150, from 40 to 100, from 60 to 80, from 100 to 300, from 150 to 250, from 0.5 to 15, from 0.6 to 10, from 0.8 to 8, from 0.9 to 5, from 1 to 4, from 0.8 to 8, from 0.9 to 5, and/or from 1 to 4, among other possibilities.

As illustrated in Figure 1, the porous fluoropolymer layer 110 overlays the opening 106. In this manner, air can be permitted to pass through the opening 106, while liquids do not pass through the porous fluoropolymer layer 110. In some examples, the opening 106 is included in a plurality of openings in the face of the metal substrate 104. In such examples, it is noted that the porous fluoropolymer layer overlays each opening of the plurality of openings such that air, but no liquid, can pass through each opening of the plurality of openings.

The fluoropolymer in the porous fluoropolymer layer 110 can be in the form of microfibers. In various examples, an internal network structure formed with microfibers of PTFE and/or ePTFE that are heat resistant and surface lubricative, and accordingly allows the dust absorbed at its surface to be readily removed.

As illustrated in Figure 1, the fabric layer 112 can have a given thickness 124 and can be disposed on a top side (a side of the porous fluoropolymer layer 110 opposite from the first surface 105 of the metal substrate 104 as illustrated in Figure 1) of the porous fluoropolymer layer 110 in Figure 1. In various examples, the fabric layer 112 can overly an entire surface area of the porous fluoropolymer layer 110, as illustrated in Figure 1. However, the disclosure is not so limited. That is, the fabric layer 112 can, in some examples, be omitted entirely from the metal fluoropolymer composite 100 or overlay a portion of, but not all of, the porous fluoropolymer layer 110.

The fabric layer 112 includes and/or is formed of fibers. The fibers can include ceramic fibers, metal fiber, metal alloy fibers, and/or polymer fibers, among other possibilities. The fibers can be formed of an inorganic material, an organic material, or combinations thereof. The fibers can be formed of a natural material, a synthetic material, or combinations thereof.

In some examples, the fibers can include carbon fibers, glass fibers, aramid fibers, and/or titanium fibers. For example, the fibers can include carbon nanotubes and/or carbon fibers. The carbon fibers can include natural carbon fibers and/or synthetic carbon fibers. For example, the carbon fibers can be formed of polyacrylonitrile ("PAN"), rayon, pitch, and/or aramid carbon fibers.

As mentioned, in some examples, the fibers can include comprise glass fibers. The glass fibers can include a ceramic, such as an oxide, a metal oxide, a silicate, a nitride, etc.

In some examples, the fibers can include polymeric fibers such as synthetic fibers. For example, the fibers can include an aramid fiber. An aramid fiber can refer to a fiber made as a result of a reaction between an amine-containing material and a carboxylic acid halide containing material, among other possibilities.

In some examples, the fibers can include metal fibers. The metal of the metal fibers can be a pure metal, a metal alloy, or combinations thereof. The metal can, for example, include a noble metal, a transition metal, or both. In some examples, the metal can include titanium.

The fibers can include continuous fibers. The fibers can include discontinuous fibers. The dimensions of the fibers can be varied. In some examples, the fibers can have an average diameter of between 5 µm and 10 µm. However, the disclosure is not so limited. Rather, larger or smaller diameters of fibers are also possible. In some examples, the fibers can a PC-ABS, nylon, polyethylene ("PE"), and/or polypropylene ("PP").

The fibers in the fabric layer 112 can be arranged in various orientations and/or directions. For example, the fibers can be aligned unidirectionally. The fabric layer 112 having the unidirectional aligned fibers can exhibit isotropic material properties. The direction can be any suitable direction, depending on the application. For example, this direction can be parallel to the larger dimension in a plane as defined by the length and width of the metal fluoropolymer composite 100, or it can be perpendicular to this dimension. The fabric layer 112 can exhibit stronger mechanical properties (e.g., elastic modulus, flexural modulus, etc.) along the unidirectional aligned direction than orthogonal thereto. As used herein, unidirectional aligned fibers refer to the fabric layer 112 having at least 80 volume % of the fibers aligned in a particular direction.

The fibers can be woven fibers. The woven fibers can be in various possible formats including plain, twill, satin, triaxial, stitched, basket, continuous strand mat, and/or veil formats.

Figure 2 illustrates a view of an example of a metal fluoropolymer composite 230 according to the disclosure. As illustrated in Figure 2, the metal fluoropolymer composite 230 includes a metal substrate 204, a porous fluoropolymer layer 210, and a fabric layer 212. The metal substrate 204, the porous fluoropolymer layer 210, the fabric layer 212 are analogous or similar to the metal substrate 104, the porous fluoropolymer layer 110, and the fabric layer 112 as described with respect to Figure 1.

As illustrated in Figure 2, the metal substrate 204 includes a plurality of openings 206-1 ,..., 206-H in a face of the metal substrate. The openings 206-1 ,..., 206-H are similar or analogous to the opening 106 described with respect to Figure 1. The openings 206-1 ,..., 206-H pass through a thickness 226 of the metal substrate 204. Stated differently, the openings pass from a first surface 205 to a second surface 208 of the metal substrate 204 to facilitate flow of air through the metal fluoropolymer composite 230. While Figure 2, illustrates two openings a total number of the openings can be varied to have fewer or a greater total number of openings to promote aspects of metal fluoropolymer composites.

As illustrated in Figure 2, the porous fluoropolymer layer 210 is disposed on a face (e.g., the first face 205) of the metal substrate and, notably, the porous fluoropolymer layer 210 overlays each opening of the plurality of openings 206-1 ,..., 206-H to facilitate flow of air through the plurality of openings 206-1,..., 206-H of the metal fluoropolymer composite 230 while ensuring the metal fluoropolymer composite 230 is impermeable to liquids.

As mentioned, the openings can have a diameter 107 up to 5.0 millimeters. The openings can have the same or similar diameters 207, 209 (as illustrated in Figure 2) or the openings can have different diameters in some examples.

The fabric layer 212 is disposed on the porous fluoropolymer layer 210, as illustrated in Figure 2. In some examples, the metal fluoropolymer composite 230 can include a finish layer 214. The finish layer 214 can be formed a variety of possible materials to provide a desired mechanical and/or aesthetic properties. In some examples, the finish layer 214 can include acrylic polymers, alkyd polymers, epoxy polymers or combinations thereof. While Figure 2 illustrates the presence of the finish layer 214 in the metal fluoropolymer composite 230 it is understood that in some examples the finish layer can be omitted similar to the metal fluoropolymer composite 130 as described with respect to Figure 1.

In some example, the porous fluoropolymer layer 210, the fabric layer 212, and/or the finish layer 214 can be laminated with or otherwise coated with other materials such as a hydrophobic and/or a oleophobic material, among other possibilities.

Each of the layers of the metal fluoropolymer composite 230 described herein has a suitable thickness to promote aspects of metal fluoropolymer composites. For example, the layers have the same thickness or different thickness. In some examples, the porous fluoropolymer layer 210 can have a thickness 225 that is greater than a thickness 224 of the fabric layer 212 and/or greater than a thickness 223 of the finish layer 214, among other possibilities.

The metal fluoropolymer composite 230 can have a thickness equal to the sum of the respective thicknesses (e.g., thicknesses 223, 224, 225, and/or 226) of the layers included in the metal fluoropolymer composite 230. In various examples, the metal fluoropolymer composite 230 can have a thickness of from 20 millimeters to 0.5 millimeters. All individual values and subranges from 20 millimeters to 0.5 millimeters are included.

Figure 3 illustrates a bottom view of an example of an electronic device 340 including a metal fluoropolymer composite according to the disclosure. As illustrated in Figure 3, the electronic device 340 includes a housing 341 including a metal fluoropolymer composite 342. The metal fluoropolymer composite 342 is analogous or similar to the metal fluoropolymer composite 100 described with respect to Figure 1 and/or the metal fluoropolymer composite 230 described with respect to Figure 2. The metal fluoropolymer composite 342 includes a plurality of openings 306-H in the face of a metal substrate (not shown in Figure 3 for ease of illustration). The openings 306-H are analogous or similar to the openings plurality of opening 106 and/or the openings 206-1, ..., 206-H described with regard to Figures 1 and 2, respectively.

The plurality of openings 306-H, notably and as illustrated in Figure 3, can be positioned adjacent to a heat producing component of the electronic device. Examples of heat producing components include processors, memory, graphics cards, and/or electrical circuits such as the electrical circuit 343, among other possible types of heat producing components that can be included in the electronic device 340.

The metal fluoropolymer composite 342 of the electronic device 340 can permit dissipation of heat (via air flow) from and/or to the inside of the electronic device 340 via the openings 306-H while being impermeable to liquid (from entering the interior of the electronic device 340). Desirably, an electronic device 340 including the metal fluoropolymer composite 342 can have an internal air temperature during operation of below 90°C, 80 °C, 70°C, 60 °C, 50°C, 40 °C, and/or 30 °C, among other possibilities. In addition, the metal fluoropolymer composite 342 can have desirably mechanical properties due at least in part to the presence of the metal substrate in the metal fluoropolymer composite 342.

The housing 341 (or at least a portion thereof) is external to the electrical circuit 343. That is, the electrical circuit 343 is disposed in an interior of the electronic device 340 that is defined at least in part by the housing 341. The electrical circuit 343 can be various types of electrical circuits having a suitable configuration and/or component to facilitate operation of the electronic device 340. It is noted that while Figure 3 illustrates the metal fluoropolymer composite 342 as forming a portion of the electronic device 340, the metal fluoropolymer composite 342 can constitute the entire cover on one side, or multiple sides, as at least a portion of the housing 341 of the electronic device 340.

In various examples, at least some of the plurality of openings 306-H can pass through the bottom cover and/or a top cover so as to be positioned adjacent to a heat producing component of the electronic device 340. For instance, the metal fluoropolymer composite 342 can form at least a bottom cover of the electronic device 340 (e.g., a bottom side of a laptop that is to contact an object such as a desk or an end-user of the laptop during operation of the laptop), as illustrated in Figure 3. In such examples, at least some of the plurality of openings 306-H can pass through the bottom cover included in the so as to be positioned adjacent to a heat producing component of the electronic device 340. Openings 306-H in Figure 3, are illustrated for ease of understanding as being visible in the bottom cover, however, it is understood that the openings 306-H pass through a metal substrate included in the metal fluoropolymer composite 342 and are not be visible from the vantage of an end-user of the electronic device 340 due in part of being overlaid at least by a porous fluoropolymer layer.

As used herein, the openings 306-H be adjacent to a heat producing component (e.g., adjacent to the electrical circuit 343) refers to the openings 306-H being in substantially the same vertical plane (e.g., a plane orthogonal to and extending through each of a metal substrate and a porous fluoropolymer layer of a bottom cover of the electronic device 340) as the heat producing component. For instance, as illustrated in Figure 3, the openings 306-H are in substantially the same vertical plane as the electrical circuit 343 of the electronic device 340. Notably, the relative proximity (e.g., a distance to the heat producing component) of the openings 306-H adjacent to the heat producing components can enhance cooling of the heat producing components as compared to other approaches that may employ vents in a side cover of an electronic device such that the vents are not substantially in a same vertical plane of a heat producing component and/or are not as proximate to the heat producing component. In some examples, the openings 306-H can include additional openings in a top cover of the electronic device 340 and/or in a side cover of the electronic device 340.

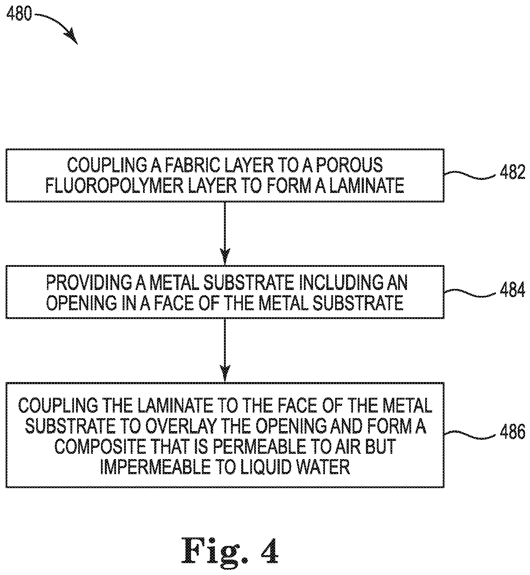

Figure 4 illustrates a flow diagram of an example of a method 480 of manufacture of a metal fluoropolymer composite according to the disclosure. As illustrated at 482, the method 480 can include coupling a fabric layer to a porous fluoropolymer layer to form a laminate. The laminate can, therefore includes at least the fabric layer and the porous fluoropolymer layer. In some examples, coupling can include exposing the fabric layer to a temperature near, at, and/or above a glass transition temperature and/or melting temperature of fibers in the fabric layer and contacting the fabric layer with the porous fluoropolymer layer to mechanically coupled the fabric layer to the porous fluoropolymer layer. Alternatively, or in addition, an adhesive, sealant, and/or a mechanical fastener can be employed to couple the fabric layer to the porous fluoropolymer layer. In some examples, coupling can include procuring a laminate having a fabric layer coupled to a porous fluoropolymer layer.

As illustrated at 484, the method 480 includes providing a metal substrate including an opening in a face of the metal substrate. Providing can include manufacture of and/or otherwise procuring the metal substrate. For example, the metal substrate can be die cast, precision milled (e.g., computer numerical controlled milling), and/or otherwise procured.

The method 480 can included coupling the laminate to the face of the metal substrate to overlay the opening and form a metal fluoropolymer composite that is permeable to air but impermeable to liquid water, as shown at 486. In some examples, coupling the laminate to the face of the metal substrate can include applying an adhesive layer to the face of the metal substrate and positioning the laminate at least partially in the adhesive layer. That is, in some examples, metal fluoropolymer composites can include an adhesive layer disposed on the face of the metal substrate (at locations other than the holes in the metal substrate) to couple the porous fluoropolymer layer to a face of the metal substrate. In various examples, the laminate (including the fabric layer and the porous fluoropolymer layer) is non-removably coupled to the metal substrate to form the metal fluoropolymer composite.

In some examples, the method 480 can include applying a hydrophobic and/or an oleophobic material to the laminate, the porous fluoropolymer layer, the fabric layer, and/or a finish layer through various manners of applications such as lamination, spray coating, dip coating, among other possible manners of application of the hydrophobic and/or an oleophobic material.

It will be understood that when an element is referred to as being "on," "connected to", "coupled to", or "coupled with" another element, it can be directly on, connected, or coupled with the other element or intervening elements may be present. In contrast, when an object is "directly coupled to" or "directly coupled with" another element it is understood that are no intervening elements (adhesives, screws, other elements) etc.

In the foregoing detailed description of the disclosure, reference is made to the accompanying drawings that form a part hereof, and in which is shown by way of illustration how examples of the disclosure may be practiced. These examples are described in sufficient detail to enable those in the art to practice the examples of this disclosure, and it is to be understood that other examples (e.g., having different thickness) may be utilized and that process, electrical, and/or structural changes may be made without departing from the scope of the disclosure.

The figures herein follow a numbering convention in which the first digit corresponds to the drawing figure number and the remaining digits identify an element or component in the drawing. For example, reference numeral 104 may refer to element 104 in Figure 1 and an analogous element may be identified by reference numeral 204 in Figure 2. Elements shown in the various figures herein can be added, exchanged, and/or eliminated so as to provide a number of additional examples of the disclosure. The proportion and the relative scale of the elements provided in the figures are intended to illustrate the examples of the disclosure, and should not be taken in a limiting sense. As used herein, "a number of" an element and/or feature can refer to one or more of such elements and/or features. Further still, while some elements are designated as a "top" or a "bottom" those in the art will recognize that such elements may correspond to other relative terms or possible orientations in some applications in order to practice the examples of this disclosure.

## Claims

1. An electronic device (340) comprising:
an electrical circuit (343);
a housing (341) exterior to the electrical circuit (343), the housing (341) being formed of a metal fluoropolymer composite (100; 230; 342) comprising:
a metal substrate (104, 204) including an opening (106; 206-1, 206-H; 306-H) in a face (105; 205) of the metal substrate (104; 204);
a porous fluoropolymer layer (110; 210, 212) disposed on the face (105; 205) of the metal substrate (104) and overlaying the opening (106; 206-1, 206-H); and
a fabric layer (112; 212) disposed on the porous fluoropolymer layer (110; 210, 212) wherein the metal fluoropolymer composite (100; 230) is permeable to air but impermeable to liquid water.

2. The electronic device (340) of claim 1, wherein the opening (206-1, 206-H; 306-H) is included in a plurality of openings in the face (105; 205) of the metal substrate (104; 204).

3. The electronic device (340) of claim 2, wherein the porous fluoropolymer layer (110; 210, 212) overlays each opening (106; 206-1, 206-H, 306-H) of the plurality of openings in the face (105; 205) of the metal substrate (104; 204).

4. The electronic device (340) of claim 1, wherein the porous fluoropolymer layer (110; 210, 212) comprises polytetrafluoroethylene (PTFE), expanded polytetrafluoroethylene (ePTFE), or combinations thereof.

5. The electronic device (340) of claim 1, wherein the fabric layer (112; 212) is disposed over an entire surface area of the porous fluoropolymer layer (110; 210, 212).

6. The electronic device (340) of claim 1, further comprises an adhesive layer disposed on the face of the metal substrate to couple the porous fluoropolymer layer (110; 210, 212) to the metal substrate.

7. The electronic device (340) of claim 2, wherein the plurality of opening (206-1, 206-H; 306-H) in the face of the metal substrate are positioned adjacent to a heat producing component of the electronic device (340).

8. The electronic device (340) of claim 7, wherein at least some openings of the plurality of openings (206-1, 206-H; 306-H) are positioned in a bottom cover of the electronic device (340) and in a vertical plane that passes through the heat producing component and the bottom cover.

9. The electronic device (340) of claim 1, wherein the fabric layer (112; 212) comprises carbon fibers, glass fibers, aramid fibers, titanium fibers, or combinations thereof.

10. The electronic device (340) of claim 1, wherein the fabric layer (112; 212) comprises unidirectional fibers, woven fibers, or combinations thereof.

## Patentansprüche

1. Elektronische Vorrichtung (340), die Folgendes umfasst:
eine elektrische Schaltung (343);
ein Gehäuse (341) außerhalb der elektrischen Schaltung (343), wobei das Gehäuse (341) aus einem Metallfluorpolymerverbund (100; 230; 342) ausgebildet ist, der Folgendes umfasst:
ein Metallsubstrat (104, 204), das eine Öffnung (106; 206-1, 206-H; 306-H) in einer Fläche (105; 205) des Metallsubstrats (104; 204) einschließt;
eine poröse Fluorpolymerschicht (110; 210, 212), die auf der Fläche (105; 205) des Metallsubstrats (104) angeordnet ist und die Öffnung (106; 206-1, 206-H) überlagert; und
eine Gewebeschicht (112; 212), die auf der porösen Fluorpolymerschicht (110; 210, 212) angeordnet ist, wobei der Metallfluorpolymerverbund (100; 230) luftdurchlässig, aber für flüssiges Wasser undurchlässig ist.

2. Elektronische Vorrichtung (340) nach Anspruch 1, wobei die Öffnung (206-1, 206-H; 306-H) in mehreren Öffnungen in der Fläche (105; 205) des Metallsubstrats (104; 204) eingeschlossen ist.

3. Elektronische Vorrichtung (340) nach Anspruch 2, wobei die poröse Fluorpolymerschicht (110; 210, 212) jede Öffnung (106; 206-1, 206-H, 306-H) der mehreren Öffnungen in der Fläche (105; 205) des Metallsubstrats (104; 204) überlagert.

4. Elektronische Vorrichtung (340) nach Anspruch 1, wobei die poröse Fluorpolymerschicht (110; 210, 212) Polytetrafluorethylen (PTFE), expandiertes Polytetrafluorethylen (ePTFE) oder Kombinationen davon umfasst.

5. Elektronische Vorrichtung (340) nach Anspruch 1, wobei die Gewebeschicht (112; 212) über einen gesamten Oberflächenbereich der porösen Fluorpolymerschicht (110; 210, 212) angeordnet ist.

6. Elektronische Vorrichtung (340) nach Anspruch 1, die ferner eine Klebstoffschicht umfasst, die auf der Fläche des Metallsubstrats angeordnet ist, um die poröse Fluorpolymerschicht (110; 210, 212) mit dem Metallsubstrat zu koppeln.

7. Elektronische Vorrichtung (340) nach Anspruch 2, wobei die mehreren Öffnungen (206-1, 206-H; 306-H) in der Fläche des Metallsubstrats angrenzend an einer wärmeerzeugenden Komponente der elektronischen Vorrichtung (340) positioniert sind.

8. Elektronische Vorrichtung (340) nach Anspruch 7, wobei wenigstens einige Öffnungen der mehreren Öffnungen (206-1, 206-H; 306-H) in einer unteren Abdeckung der elektronischen Vorrichtung (340) und in einer vertikalen Ebene, die durch die wärmeerzeugende Komponente und die untere Abdeckung verläuft, positioniert sind.

9. Elektronische Vorrichtung (340) nach Anspruch 1, wobei die Gewebeschicht (112; 212) Kohlenstofffasern, Glasfasern, Aramidfasern, Titanfasern oder Kombinationen davon umfasst.

10. Elektronische Vorrichtung (340) nach Anspruch 1, wobei die Gewebeschicht (112; 212) unidirektionale Fasern, gewebte Fasern oder Kombinationen davon umfasst.

## Revendications

1. Dispositif électronique (340) comprenant :
un circuit électrique (343) ;
un boîtier (341) extérieur au circuit électrique (343), le boîtier (341) étant formé d'un composite de polymère fluoré métallique (100 ; 230 ; 342) comprenant :
un substrat métallique (104, 204) comportant une ouverture (106 ; 206-1, 206-H ; 306-H) dans une face (105 ; 205) du substrat métallique (104 ; 204) ;
une couche poreuse de polymère fluoré (110 ; 210, 212) disposée sur la face (105 ; 205) du substrat métallique (104) et recouvrant l'ouverture (106 ; 206-1, 206-H) ; et
une couche de tissu (112 ; 212) disposée sur la couche poreuse de polymère fluoré (110 ; 210, 212), le composite de polymère fluoré métallique (100 ; 230) étant perméable à l'air mais imperméable à l'eau liquide.

2. Dispositif électronique (340) selon la revendication 1, l'ouverture (206-1, 206-H ; 306-H) étant incluse dans une pluralité d'ouvertures dans la face (105 ; 205) du substrat métallique (104 ; 204).

3. Dispositif électronique (340) selon la revendication 2, la couche poreuse de polymère fluoré (110 ; 210, 212) recouvrant chaque ouverture (106 ; 206-1, 206-H, 306-H) de la pluralité d'ouvertures dans la face (105 ; 205) du substrat métallique (104 ; 204).

4. Dispositif électronique (340) selon la revendication 1, la couche poreuse de polymère fluoré (110 ; 210, 212) comprenant du polytétrafluoroéthylène (PTFE), du polytétrafluoroéthylène expansé (ePTFE) ou des combinaisons de ceux-ci.

5. Dispositif électronique (340) selon la revendication 1, la couche de tissu (112 ; 212) étant disposée sur une surface entière de la couche poreuse de polymère fluoré (110 ; 210, 212).

6. Dispositif électronique (340) selon la revendication 1, comprenant en outre une couche adhésive disposée sur la face du substrat métallique pour accoupler la couche poreuse de polymère fluoré (110 ; 210, 212) au substrat métallique.

7. Dispositif électronique (340) selon la revendication 2, la pluralité d'ouvertures (206-1, 206-H ; 306-H) dans la face du substrat métallique étant positionnées de manière adjacente à un composant produisant de la chaleur du dispositif électronique (340).

8. Dispositif électronique (340) selon la revendication 7, au moins certaines ouvertures de la pluralité d'ouvertures (206-1, 206-H ; 306-H) étant positionnées dans un couvercle inférieur du dispositif électronique (340) et dans un plan vertical qui traverse le composant produisant de la chaleur et le couvercle inférieur.

9. Dispositif électronique (340) selon la revendication 1, la couche de tissu (112 ; 212) comprenant des fibres de carbone, des fibres de verre, des fibres d'aramide, des fibres de titane ou des combinaisons de celles-ci.

10. Dispositif électronique (340) selon la revendication 1, la couche de tissu (112 ; 212) comprenant des fibres unidirectionnelles, des fibres tissées ou des combinaisons de celles-ci.
